# EUROPEAN PATENT APPLICATION

(11) **EP 4 601 017 A1**
(43) Date of publication of application: **13.08.2025**
(21) Application number: 24169780.4
(22) Date of filing: 11.04.2024
(51) Int. Cl.: H01L 31/0352, H01L 31/0216, H01L 31/042

(54) **SOLAR CELL AND PHOTOVOLTAIC MODULE**

(30) Priority: 06.02.2024 CN 202410172616
(71) Applicant: Zhejiang Jinko Solar Co., Ltd., Haining, Zhejiang (CN)
(72) Inventor: LI, Huimin, Haining, Zhejiang (CN); XU, Menglei, Haining, Zhejiang (CN); YANG, Jie, Haining, Zhejiang (CN); ZHANG, Xinyu, Haining, Zhejiang (CN)
(74) Representative: Balder IP Law, S.L.

(57) **Abstract**

Disclosed are a solar cell and a photovoltaic module. The solar cell includes a substrate and a doped semiconductor layer disposed on the substrate. The solar cell further includes holes distributed across an edge region of the doped semiconductor layer, and a respective hole of the holes extending through at least the doped semiconductor layer and being filled with a passivation material. The solar cell further includes a passivation layer formed on a side of the doped semiconductor layer away from the substrate, and a plurality of electrodes arranged at intervals along a first direction, extending through the passivation layer and in electrical contact with the doped semiconductor layer.

## Description

### TECHNICAL FIELD

Embodiments of the present disclosure relate to the field of photovoltaics and, in particular, to a solar cell and a photovoltaic module.

### BACKGROUND

At present, as fossil fuels are gradually exhausted, solar cells have wider applications as a new energy alternative solution. A solar cell is an apparatus that converts light energy of the sun into electric energy. The solar cell generates carriers by using a photovoltaic effect principle and introduces the carriers out by using an electrode, which is conducive to effective utilization of the electric energy.

A Tunnel Oxide Passivated Contact (hereinafter TOPCon) cell or A TOPCon-BC (hereinafter TBC) cell constituted by combining TOPCon technology with interdigitated back contact (hereinafter IBC) technology are required to prepare a passivation contact structure on a surface of a silicon substrate. For example, an ultrathin tunneling oxide layer and a highly doped polysilicon layer may be used as the passivation contact structure, a chemical passivation of the tunneling oxide layer and a field passivation of the polysilicon layer may be utilized to significantly reduce a recombination rate of minority carriers of the surface of the silicon substrate, meanwhile the highly doped polysilicon layer can significantly improve an electric conductivity property of majority carriers, which are advantageous to increase an open circuit voltage and a fill factor of the cell.

Chemical Vapor Deposition (CVD) is a major technology for preparation of the tunneling oxide layer and the polysilicon layer, for example, Low Pressure Chemical Vapor Deposition (LPCVD) has advantages of low cost, high yield, and high performance of the produced thin films, and has been widely used. However, there may be some problems in the process of preparing a back contact passivation structure, which may affect an efficiency of the cell.

### SUMMARY

In accordance with some embodiments of the present disclosure, in one aspect, a solar cell is provided and incudes a substrate, and a doped semiconductor layer disposed on the substrate. The solar cell further includes holes distributed across an edge region of the doped semiconductor layer, a respective hole of the holes extending through at least the doped semiconductor layer and being filled with a passivation material. The solar cell further includes a passivation layer formed on a side of the doped semiconductor layer away from the substrate, and a plurality of electrodes arranged at intervals along a first direction, extending through the passivation layer and in electrical contact with the doped semiconductor layer.

In some embodiments, the doped semiconductor layer is doped with P-type doping elements, the edge region has a width less than or equal to 50µm in the first direction.

In some embodiments, the respective hole has a one-dimensional size less than or equal to 10µm.

In some embodiments, the doped semiconductor layer is doped with N-type doping elements, the edge region has a width less than or equal to 300µm in the first direction.

In some embodiments, the respective hole has a one-dimensional size less than or equal to 30µm.

In some embodiments, the substrate is provided with recesses, a respective recess of the recesses communicates with the respective hole, and the respective recess has a depth less than 4µm.

In some embodiments, a portion of the plurality of electrodes are arranged in the holes and are in electrical contact with the substrate.

In some embodiments, the substrate is provided with textured structures in an inner wall of the recesses.

In some embodiments, the textured structures include at least one positive pyramid, and the respective hole corresponds to 1 to 5 positive pyramids in the at least one positive pyramid.

In some embodiments, the plurality of electrodes are in contact with the at least one positive pyramid.

In some embodiments, the solar cell further includes a dielectric layer between the substrate and the doped semiconductor layer, where the respective hole further extends through the dielectric layer to reach a surface of the substrate.

In some embodiments, the substrate is provided with P regions, N regions and gap regions, the P regions and the N regions are arranged alternatingly, a respective gap region of the gap regions is sandwiched between a respective P region of the P regions and a N region adjacent to the respective P region in the N regions. The doped semiconductor layer includes a first portion arranged at the P regions and a second portion arranged at the N regions. The plurality of electrodes include first electrodes in electrical contact with the first portion and second electrodes in electrical contact with the second portion. The passivation layer further covers a surface of the substrate at the gap regions. The first portion has a first edge region, a portion of the holes is provided at the first edge region, and/or the second portion has a second edge region, another portion of the holes is provided at the second edge region.

In some embodiments, a respective hole provided at the first edge region has a one-dimensional size less than a one-dimensional size of a respective hole provided at the second edge region.

In some embodiments, the gap regions are level with the P regions and the N regions.

In some embodiments, the substrate has a first surface and a second surface opposite to the first surface, and is provided with a first textured structure on the first surface and a first textured structure on a surface of the gap regions; the first textured structure has a roughness greater than or equal to the roughness of the second textured structure.

In some embodiments, in a third direction, a ratio of a number of the holes to a length of the edge region is less than 0.2/µm.

In some embodiments, the doped semiconductor layer has a boundary, a number of the holes near the boundary is greater than a number of the holes away from the boundary.

In some embodiments, the doped semiconductor layer includes at least one of a doped amorphous silicon layer, a doped polycrystalline silicon layer, a doped microcrystalline silicon layer, a doped silicon carbide layer, and a doped crystalline silicon layer.

In some embodiments, the doped semiconductor layer is doped with doping elements of a same type as the substrate.

According to some embodiments, in another aspect, a photovoltaic module is provided and includes: at least one cell string formed by connecting a plurality of solar cells as described above, at least one encapsulation film formed over surfaces of the at least one cell string, and at least one cover plate formed over surfaces of the at least one encapsulation film facing away from the at least one cell string.

### BRIEF DESCRIPTION OF THE DRAWINGS

One or more embodiments are described by way of example with reference to the corresponding figures in the accompanying drawings, and the exemplary description is not to be construed as limiting the embodiments. Elements in the accompanying drawings that have same reference signs are represented as similar elements, and unless otherwise particularly stated, the figures in the accompanying drawings are not drawn to scale. To describe the technical solutions of the embodiments of the present disclosure or the related art more clearly, the accompanying drawings that need to be used in the embodiments are briefly described below. Apparently, the accompanying drawings in the following description show only some embodiments of the present disclosure, and a person of ordinary skill in the art may still derive other drawings from these accompanying drawings without creative efforts.
FIG. 1 is a schematic diagram illustrating a structure of a solar cell in accordance with an embodiment of the present disclosure;
FIG. 2 is an enlarged partial view at C in FIG. 1;
FIG. 3 is a schematic diagram illustrating a cross-sectional view taken along a line A1-A2 in FIG. 2;
FIG. 4 is a schematic diagram illustrating a structure of a doped semiconductor layer in a solar cell in accordance with an embodiment of the present disclosure;
FIG. 5 is a schematic diagram showing various configuration examples of a first hole in a solar cell in accordance with an embodiment of the present disclosure;
FIG. 6 is a schematic diagram illustrating a surface structure of a doped semiconductor layer in a solar cell in accordance with an embodiment of the present disclosure;
FIG. 7 is a schematic diagram illustrating a cross-sectional view of a doped semiconductor layer in a solar cell in accordance with an embodiment of the present disclosure;
FIG. 8 is a schematic diagram illustrating another structure of a first hole in a solar cell in accordance with an embodiment of the present disclosure;
FIG. 9 is a schematic diagram illustrating a cross-sectional view of a first structure of a solar cell in accordance with an embodiment of the present disclosure;
FIG. 10 is a schematic diagram illustrating a cross-sectional view of a second structure of a solar cell in accordance with an embodiment of the present disclosure;
FIG. 11 is a schematic diagram illustrating another structure of a solar cell in accordance with an embodiment of the present disclosure;
FIG. 12 is an enlarged partial view at D in FIG. 11;
FIG. 13 is a schematic diagram illustrating a cross-sectional view taken along a line B 1-B2 in FIG. 12;
FIG. 14 is a schematic diagram illustrating a structure of a solar cell corresponding to an operation of providing a substrate in a method of preparing the solar cell in accordance with an embodiment of the present disclosure;
FIG. 15 is a schematic diagram illustrating a structure of a solar cell corresponding to an operation of removing a first doped silicon glass layer in a method of preparing the solar cell in accordance with an embodiment of the present disclosure;
FIG. 16 is a schematic diagram illustrating a structure of a solar cell corresponding to an operation of forming a second doped silicon glass layer in a method of preparing the solar cell in accordance with an embodiment of the present disclosure;
FIG. 17 is a schematic diagram illustrating a structure of a solar cell corresponding to an operation of removing the second doped silicon glass layer in a method of preparing the solar cell in accordance with an embodiment of the present disclosure;
FIG. 18 is a schematic diagram illustrating a structure of a tandem solar cell according to an embodiment of the present disclosure;
FIG. 19 is a schematic diagram illustrating a structure of a photovoltaic module in accordance with an embodiment of the present disclosure; and
FIG. 20 is a schematic diagram illustrating a cross-sectional view taken along a line M1-M2 in FIG. 19.

### DETAILED DESCRIPTION OF THE EMBODIMENTS

It can be seen from the BACKGROUND that current solar cells have poor photoelectric conversion efficiency.

Embodiments of the present disclosure provide a solar cell and a photovoltaic module, the doped semiconductor layer is provided with an edge region, and first holes are provided within the edge region, a passivation layer is arranged within the first holes and provide passivation to the substrate, so that the passivation layer can provide passivation to the substrate exposed by the doped semiconducting layer, thereby reducing surface defects of the substrate, and reducing recombination rate of the substrate. The doped semiconductor layer is provided with the first holes at the edge region, a structural strength of the doped semiconductor layer decreases correspondingly due to the plurality of first holes, the doped semiconducting layer including the first holes may relieve a compressive stress to which the doped semiconducting layer is subjected during forming an electrode on the doped semiconducting layer with the first holes at the edge region and achieving a welding between the electrode and a solder band and during a lamination process of a photovoltaic module, thereby reducing a chance of breakage of the doped semiconducting layer at the edge and improving a yield of the solar cell.

Various embodiments of the present disclosure will now be described in detail with reference to the accompanying drawings. However, those of ordinary skill in the art will appreciate that, in various embodiments of the present disclosure, numerous technical details are set forth in order to provide the reader with a better understanding of the present disclosure. However, the claimed subject matter of the present disclosure can be implemented without these technical details and various variations and modifications based on the following embodiments.

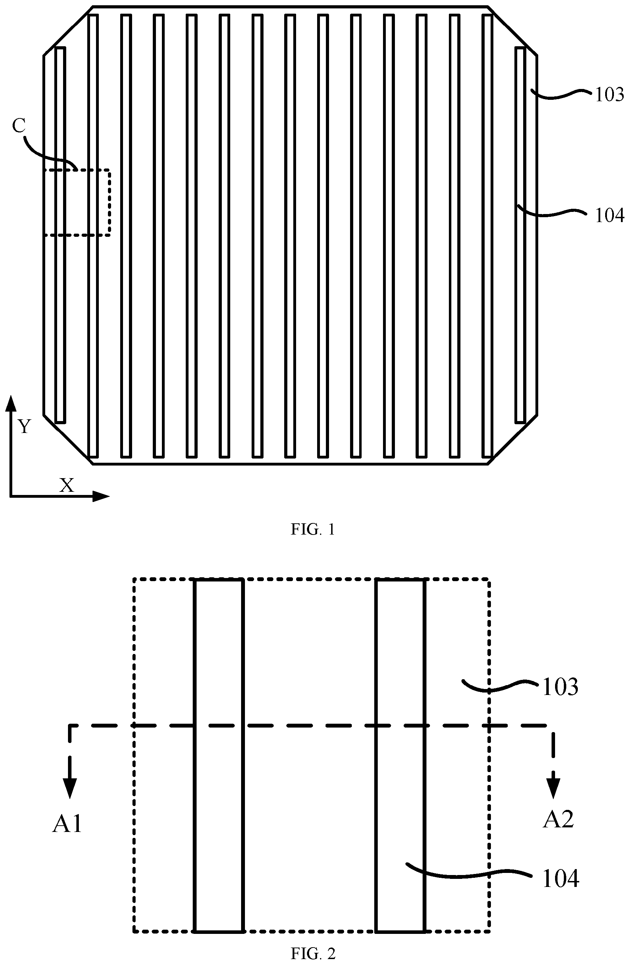

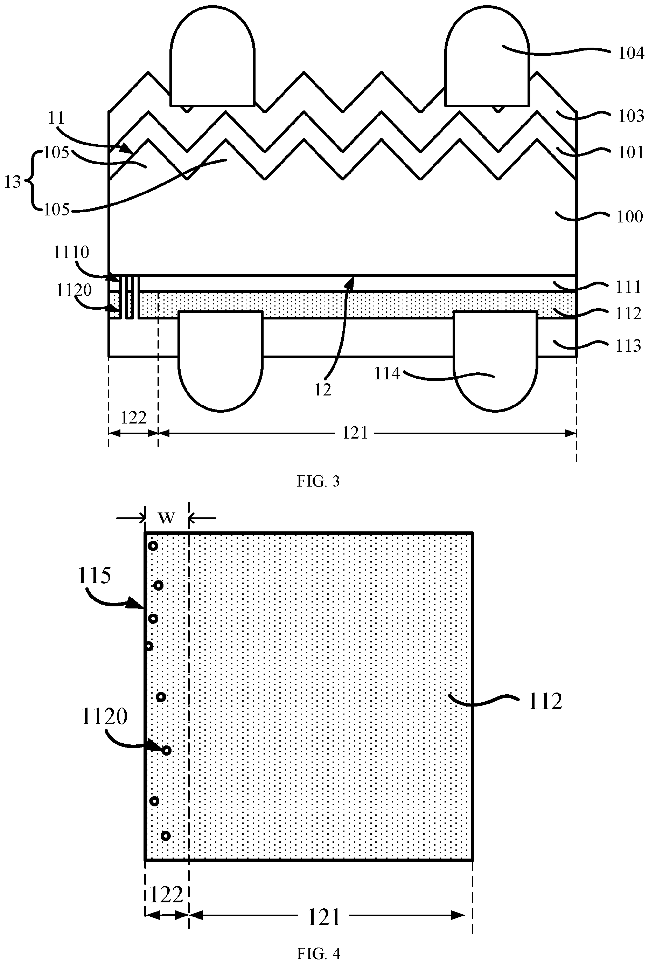

FIG. 1 is schematic diagram illustrating a structure of a solar cell in accordance with an embodiment of the present disclosure; FIG. 2 is an enlarged partial view at C in FIG. 1; FIG. 3 is a schematic diagram illustrating a cross-sectional view taken along a line A1-A2 in FIG. 2; FIG. 4 is a schematic diagram illustrating a structure of a doped semiconductor layer in a solar cell in accordance with an embodiment of the present disclosure.

Referring to FIG. 1 to FIG. 4, according to some embodiments of the present disclosure, in one aspect, a solar cell is provided. The solar cell includes a substrate 100 and a doped semiconductor layer 112 disposed on a side of the substrate 100. The doped semiconductor layer 112 includes an edge region 122, and is provided with first holes 1120 passing through the doped semiconductor layer 112 at the edge region 122. The solar cell further includes a passivation layer 113 formed over the doped semiconductor layer 112, and filling the first holes 1120. The solar cell further includes a plurality of electrodes 114 arranged along a first direction X, and the plurality of electrodes 114 pass through the passivation layer 113 and are in electrical contact with the doped semiconductor layer 112.

In some embodiments, the substrate 100 may be made of an elementary semiconductor material. Specifically, the elementary semiconductor material consists of a single element, for example, may be silicon or germanium. The elementary semiconductor material may be in a monocrystalline state, a polycrystalline state, an amorphous state, or a microcrystalline state (a state with both monocrystalline and amorphous states is referred to as microcrystalline state), and for example, the silicon may be at least one of monocrystalline silicon, polycrystalline silicon, amorphous silicon, or microcrystalline silicon.

In some embodiments, the substrate 100 may also be made of a compound semiconductor material. Common compound semiconductor materials include, but are not limited to, silicon germanium, silicon carbide, gallium arsenide, indium gallium, perovskite, cadmium telluride, copper indium selenide, and the like. The substrate 100 may also be a sapphire substrate, a silicon-on-insulator substrate, or a germanium-on-insulator substrate.

In some embodiments, the substrate 100 may be an N-type semiconductor substrate or a P-type semiconductor substrate. The N-type semiconductor substrate is doped with N-type doping elements, the N-type doping elements may be any of Group V elements such as phosphorus (P), bismuth (Bi), antimony (Sb), or arsenic (As). The P-type semiconductor substrate is doped with P-type doping elements, and the P-type doped elements may be any of Group III elements such as boron (B), aluminum (Al), gallium (Ga), or indium (In).

In some embodiments, the substrate 100 has a first surface 11 and a second surface 12 opposite to the first surface 11. The first surface 11 of the substrate 100 may be a front surface and the second surface 12 is a rear surface, or the first surface of the substrate may be a rear surface and the second surface is a front surface. The solar cell is a single-sided cell, the front surface serves as a light receiving surface for receiving incident light and the rear surface serves as a light shading surface. In some embodiments, the solar cell is a bifacial cell, i.e., both of the first surface and the second surface of the substrate may serve as light receiving surfaces, both are operable to receive incident light. Here, the light shading surface may also receive incident light, except that an efficiency of receiving the incident light by the light shading surface is weaker than the efficiency of receiving the incident light by the light receiving surface.

In the solar cell shown in FIG. 3, FIG. 9, FIG. 10 and FIG. 13 described below, the first surface of the substrate is the front surface and the second surface of the substrate is the rear surface, and the solutions of the solar cell shown in FIG. 3, FIGS. 9, 10 and 13 described below are modified on the rear surface of the solar cell and the doped semiconductor layer 112 is arranged on the rear surface of the substrate, to improve the passivation performance of the rear surface of the solar cell. In the solar cell shown in FIG. 3, FIG. 9, FIG. 10 and FIG. 13 described below, a side of the substrate facing upward serves as the light receiving surface and the side of the substrate facing downward serves as the light shading surface. In some embodiments, the doped semiconductor layer 112 may also be arranged on the first surface, the doped semiconductor layer 112 is disposed on the front surface, and embodiments of the present disclosure does not constitute a limitation on the arrangement of the doped semiconductor layer 112 on the first surface as well as on the second surface, only needed is that the doped semiconductor layer 112 is arranged on the surface of the substrate.

In some embodiments, the solar cell further includes a dielectric layer 111 arranged between the substrate 100 and the doped semiconductor layer 112. second holes 1110 are defined in the dielectric layer 111 and correspond to the first holes 1120, a bottom of a respective second hole of the second holes 1110 exposes the surface of the substrate 100.

It should be noted that, since the dielectric layer 111 generally serves to guarantee a tunneling functionality of carriers, such that the carriers can tunnel into the doped semiconductor layer 112 via the dielectric layer 111, the dielectric layer 111 is generally thin, and the thickness of the dielectric layer 111 is less than 15 nm, so that during formation of the first holes 1120, the dielectric layer 111 exposed by the first holes 1120 may be correspondingly removed, such that the second holes 1110 are formed within the dielectric layer 111. In some embodiments, the formation of the first holes does not completely causes etch damage to the dielectric layer, the second holes are not generated in the dielectric layer, which is within the protection scope of embodiments of the present disclosure.

In some embodiments, a passivation contact structure is formed between the dielectric layer 111 and the doped semiconductor layer 112, the doped semiconductor layer 112 is capable of forming a band-bending at the surface of the substrate 100, the dielectric layer 111 makes the energy band at the surface of the substrate 100 asymmetrically shift, such that a barrier to majority carriers in the carriers is lower than the barrier to minority carriers in the carriers, so that the majority carriers can more easily undergo quantum tunneling through the dielectric layer 111 and the minority carriers have difficulty passing through the dielectric layer 111, thereby enabling selective transport of the carriers.

Further, the dielectric layer 111 acts as a chemical passivation. Specifically, since the presence of interface state defects at the interface between the substrate 100 and the dielectric layer 111, an interface state density at the front surface of the substrate 100 is relatively large, the increased interface state density promotes recombination of photogenerated carriers, increases a fill factor, short circuit current, and open circuit voltage of the solar cell, thereby increasing a photoelectric conversion efficiency of the solar cell. The dielectric layer 111 is disposed on the second surface 12 of the substrate 100, such that the dielectric layer 111 acts chemical passivation on the surface of the substrate 100, specifically by saturating dangling bonds of the substrate 100, reducing a defect state density of the substrate 100, and reducing recombination centers of the substrate 100 to reduce carrier recombination rate.

In some embodiments, the dielectric layer 111 has a thickness in a range of 0.5 nm to 5 nm. The thickness of the dielectric layer 111 may range from 0.5 nm to 1.3 nm, 1.3 nm to 2.6 nm, 2.6 nm to 4.1 nm, or 4.1 nm to 5 nm. Within any of the above ranges, the thickness of the dielectric layer 111 is relatively thin, and the majority carriers can more easily undergo quantum tunneling through the dielectric layer 111, and the minority carriers have difficulty to pass through the dielectric layer 111, thereby achieving selective transport of carriers.

In some embodiments, the doped semiconductor layer 112 acts as a field passivation. Specifically, an electrostatic field directing towards an interior of the substrate 100 is formed at the surface of the substrate 100, and the minority carriers are caused to escape the interface, thereby reducing a minority carrier concentration, such that the carrier recombination rate at the interface of the substrate 100 is reduced, thereby increasing the open circuit voltage, the short circuit current and fill factor of the solar cell, and improving the photoelectric conversion efficiency of the solar cell.

The doped semiconductor layer 112 may be doped with doping element of the same type as the substrate 100, e.g., the doping element of the substrate 100 is N-type, and the doped semiconductor layer 112 is doped with N-type doping elements.

In some embodiments, the doped semiconductor layer 112 includes at least one of a doped amorphous silicon layer, a doped polysilicon layer, a doped microcrystalline silicon layer, a doped silicon carbide layer, or a doped crystalline silicon layer.

In some embodiments, with reference to FIG. 4, the doped semiconductor layer 112 is doped with P-type doping elements, and the edge region 122 has a width w of less than or equal to 50µm in the first direction. The width w of the edge region 122 is less than or equal to 45µm, the width w of the edge region 122 is less than or equal to 39µm, or the width w of the edge region 122 is less than or equal to 30µm. As such, the width w of the edge region 122 of the doped semiconductor layer 112 is within any of the above ranges and an area occupied by the first holes 1120 is relatively less, so that the first holes 1120 have less effect on the entire doped semiconductor layer 112, thereby increasing the passivation effect of the doped semiconductor layer 112 on the substrate. With the edge region 122 of the doped semiconductor layer 112 in any of the above ranges, the doped semiconductor layer 112 may establish a part of tunneling channels for increasing the chance that the carriers within the substrate 100 tunnel from the first holes 1120 to the electrodes 114, and thus are collected by the electrodes 114. In some embodiments, to ensure that regions contacted by the electrodes 114 are all highly doped regions, and thus to reduce a contact resistance between the electrode 114 and the doped semiconductor layer 112, the area of the doped semiconductor layer 112 is generally larger than the area of the electrodes 114, the extent of the edge region 122 in present disclosure is controlled to be smaller, thereby reducing the effect of the first hole 1120 on the electrodes 114 and thereby improving the photoelectric conversion efficiency of the cell. The edge region 122 provided with the first holes 1120 can also reduce recombination defects of a part of the doped semiconductor layer 112 which is not in electrode regions.

In some embodiments, a single first hole 1120 has a one-dimensional size d less than or equal to 10µm. The one-dimensional size d of the single first hole 1120 is less than or equal to 8µm, the one-dimensional size d of the single first hole 1120 is less than or equal to 5.8µm, or the one-dimensional size d of the single first hole 1120 is less than or equal to 4.3µm, the range of the one-dimensional size d of the single first hole 1120 is in any of the above ranges, a aperture of the single first hole 1120 is small, such that the presence of the first holes 1120 have less influence on a strength of the doped semiconductor layer 112 per se, without causing a peeling between the doped semiconductor layer 112 and the substrate 100. Having the one-dimensional size of d within any of the above ranges, the first holes 1120 may also be filled by the passivation layer 113 without forming a void, thereby improving a cell efficiency of the solar cell.

In some embodiments, the one-dimensional size d of the single first hole 1120 is in any of the ranges described above, and the number of the first holes 1120 and the one-dimensional size d can be used to provide space for a thermal deformation of the doped semiconductor layer 112 and a thermal deformation of the passivation layer 113, to reduce a chance of curling of the solar cell.

In some embodiments, the doped semiconductor layer 112 is doped with N-type doping elements, the edge region 122 has a width w less than or equal to 300µm in the first direction. The width w of the edge region 122 is less than or equal to 280µm. The width w of the edge region 122 is less than or equal to 250µm. The width w of the edge region 122 is less than or equal to 200µm. Serving as an acceptor element, the N-type doped element can promote a growth of grains used to build up the doped semiconducting layer 112 in the operations of doping and diffusing during a preparation of the doped semiconducting layer 112, thereby promoting a tighter and rougher morphology of the surface of the doped semiconducting layer 112. The tightness and roughness of the surface of the doped semiconductor layer 112 may reduce the effect of the external environment on the doped semiconductor layer 112 in subsequent etching processes, thereby improving the passivation performance of the doped semiconductor layer 112 per se, reducing the extent of the first holes 1120 within the doped semiconductor layer 112 and the sizes of the first holes 1120.

With respect to a definition of the edge region 122, the edge region 122 of the P-type doped semiconductor layer having a width w of less than or equal to 50µm in embodiments of the present disclosure refers to, in a doped semiconductor, a region enclosed by a width of less than or equal to 50µm from a boundary of the doped semiconductor layer 112, and the other region is defined as a first region. The edge region 122 of the N-type doped semiconductor layer having a width w less than or equal to 300µm refers to, in a doped semiconductor, a region enclosed by a width of less than or equal to 300µm from a boundary of the doped semiconductor layer 112, and the other region is defined as a first region.

In some embodiments, the single first hole 1120 has the one-dimensional size d less than or equal to 30µm. The one-dimensional size d of the single first hole 1120 is less than or equal to 28µm, is less than or equal to 23µm, or is less than or equal to 20µm.

In some embodiments, the doped semiconductor layer 112 is doped with the N-type doping element, the N-type doping element causes the doped semiconductor layer 112 to have uniform grains and to have a single crystal structure, and the doped semiconductor layer 112 with the N-type doping element has smaller particles, a larger number of grain boundaries and uniform grain boundaries, and the one-dimensional size d of the formed first hole 1120 is larger.

In some embodiments, the doped semiconductor layer 112 is doped with the P-type doping element, there is better compatibility between the P-type doped element and the dielectric layer 111. Taking the P-type doped element being the B element as an example, the B element may form a B-O bond with the oxygen element and a B-Si bond with the silicon element, thereby allowing better contact performance between the doped semiconductor layer 112 and the dielectric layer 111, such that an extent of the edge region is smaller and the one-dimensional size d of the formed first hole 1120 is smaller.

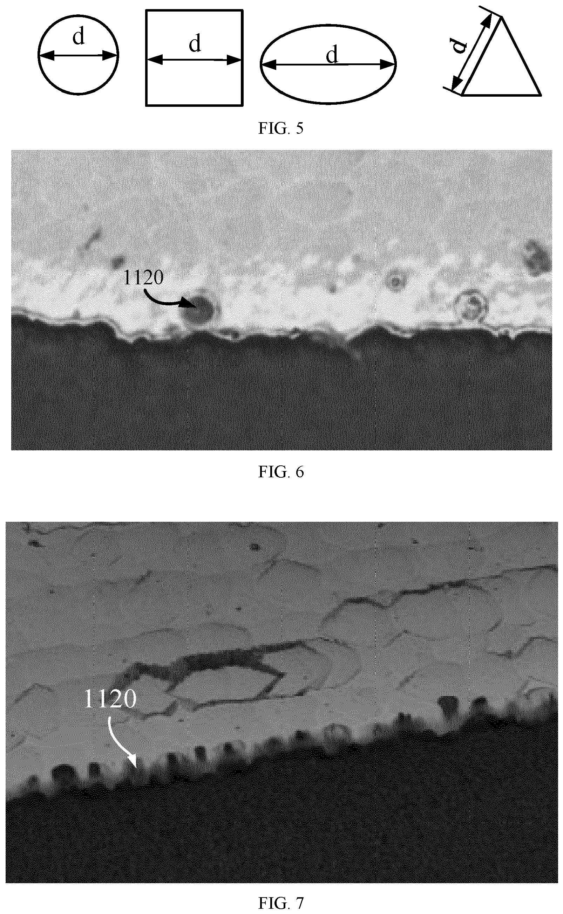

In some embodiments, referring to FIG. 5, which shows various configuration examples of the single first hole in the solar cell in accordance with an embodiment of the present disclosure, the shape of the single first hole 1120 may be circular, rectangular, oval, or triangular as shown in FIG. 5.

In some embodiments, the one-dimensional size d of the single first hole 1120 may be the diameter of a circle, length of a side of a rectangle or triangle, or length of a major axis of an ellipse, and the one-dimensional size d may also be length of a connecting line between two corners.

FIG. 6 is a schematic diagram illustrating a surface structure of a doped semiconductor layer in a solar cell in accordance with an embodiment of the present disclosure, and FIG. 7 is a schematic diagram illustrating a cross-sectional view of a doped semiconductor layer in a solar cell in accordance with an embodiment of the present disclosure.

Referring to FIG. 4, FIG. 6 and FIG. 7, the doped semiconductor layer 112 has a boundary 115, the number of first holes 1120 near the boundary 115 is greater than the number of first holes 1120 away from the boundary 115. As such, the number of first holes 1120 near the boundary 115 is relatively large, whereas the number of first holes 1120 away from the boundary 115 is relatively small, the number of the electrodes located within the first holes 1120 is also reduced, so as to increase the collection area of the electrodes 114. The greater number of first holes 1120 near the boundary 115 results in a lesser strength of the doped semiconductor layer 112 near the boundary 115 and a corresponding decrease in the chance of edge breakage.

In some embodiments, referring to FIG. 7, the first holes 1120 near the boundary 115 are spaced apart and discontinuous, as such, the one-dimensional size d of the first hole 1120 is smaller, every two first holes 1120 are further separated by the doped semiconductor layer 112, and for the edge region of the substrate, the doped semiconductor layer 112 is also used to collect carriers of the substrate and the carriers are eventually collected by the electrodes.

In some embodiments, the greater number of first holes 1120 near the boundary 115 results in a corresponding decrease of a total doping concentration of the doped semiconductor layer 112 at the edge region 122, which in turn can reduce the chance of electric leakage at the edge.

In some embodiments, a ratio of the number of first holes 1120 to the length of the edge region is less than 0.2/µm along a third direction, i.e., along a direction of the boundary of the doped semiconductor layer 112 towards the first region, for every 100µm length of the doped semiconductor layer 112, the number of first holes 1120 is less than 20, further the number of first holes 1120 is less than 18, 16, 13 or 10. The number of the first holes 1120 is within any of the above ranges, thus the passivation performance of the doped semiconductor layer 112 can be improved, a disruption of tunneling performance of the dielectric layer 111 is reduced, and the breakage of edges of the doped semiconductor layer 112 can also be reduced and deformation resistance to thermal radiation of the solar cell sheet is improved.

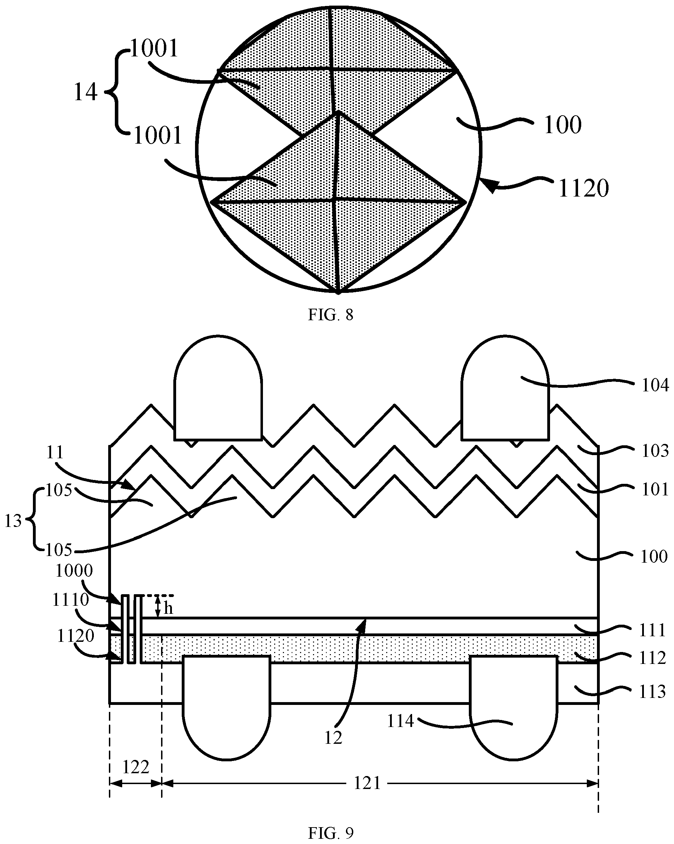

FIG. 9 is a schematic diagram illustrating a cross-sectional view of a first structure of a solar cell in accordance with an embodiment of the present disclosure. In some embodiments, the substrate 100 is provided with recesses 1000. A respective recess 1000 communicates with a corresponding first hole 1120. A single recess 1000has a depth h less than 4µm. The depth h of the single recess 1000 is less than 3.6µm, the depth h of the single recess 1000 is less than 3.3µm, or the depth h of the single recess 1000 is less than 2.8µm.

In some embodiments, the doped semiconductor layer 112 is doped with the N-type doping elements, the depth h of the single recess 1000 is less than 3µm. In some embodiments, the doped semiconductor layer 112 is doped with the P-type dopant elements, the depth h of the single recess 1000 is less than 4µm.

In some embodiments, the depth h of the single recess 1000 is in any of the above ranges, thus a situation that the recesses 1000 pass through the substrate 100 and then results in a breakdown of the substrate can be avoided, and the recesses 1000 may also serve as a light trapping structure to improve internal reflection of the solar cell.

In some embodiments, FIG. 8 is a schematic diagram illustrating another structure of a first hole in a solar cell in accordance with an embodiment of the present disclosure. With reference to FIG. 8 and FIG. 9, an inner wall of a single recess 1000 is provided with textured structures 14. The textured structures 14 are formed on the surface of the substrate 100. The textured structures 14, together with the recess 1000, constitutes a light trapping structure, and the textured structures 14 can increase the internal reflection of sunlight and thereby increase a light absorption rate at the edge region 122.

In some embodiments, the textured structures 14 may include a pyramidal structure, a prismatic structure, or a raised structure. The pyramidal structure includes an inverted pyramid and a positive pyramid. FIG. 8 takes the textured structure 14 including two positive pyramids 1001 as an example.

In some embodiments, 1 to 5 positive pyramids 1001 may be arranged in one first hole 1120, so as to increase the internal reflection of incident light, thereby improving the photoelectric conversion efficiency. The number of the positive pyramids 1001 within one first hole 1120 is in the above range, the size of the positive pyramids 1001 is relatively large, the defects on the surface of the substrate 100 are relatively small, the recombination center of the substrate 100 is small, and the passivation layer 113 can form good passivation for the substrate 100.

In some embodiments, the electrode 114 is in contact with the positive pyramid 1001, so as to increase a contact area between the positive pyramid 1001 and the electrode 114, thereby enhancing a contact performance between the electrode 114 and the positive pyramid 1001 as well as increasing the yield of the cell.

In some embodiments, a region of the doped semiconductor layer 112 other than the edge region is defined as the first region 121. The solar cell in FIG. 4 shows a part of the edge region 122, the positional relationship between the edge region 122 and the first region 121 may be that the edge region 122 surrounds a central region (i.e. the first region) or that the edge region 122 is located at one end of the first region 121.

In some embodiments, the passivation layer 113 may be of a single layer structure or a stacked layer structure, and may be made of one or more of silicon oxide, silicon nitride, silicon oxynitride, silicon oxycarbonitride, titanium oxide, hafnium oxide, or aluminum oxide.

In some embodiments, the solar cell further includes an antireflection layer formed over the passivation layer, and the electrodes pass through the antireflection layer and the passivation layer and is in electrical contact with the doped semiconductor layer. The antireflection layer serves to reduce or eliminate reflected light from the surface of the solar cell, thereby increasing the amount of light transmission from the surface of the solar cell, reducing or eliminating stray light from a system. the antireflective layer may be made of silicon nitride or silicon oxynitride.

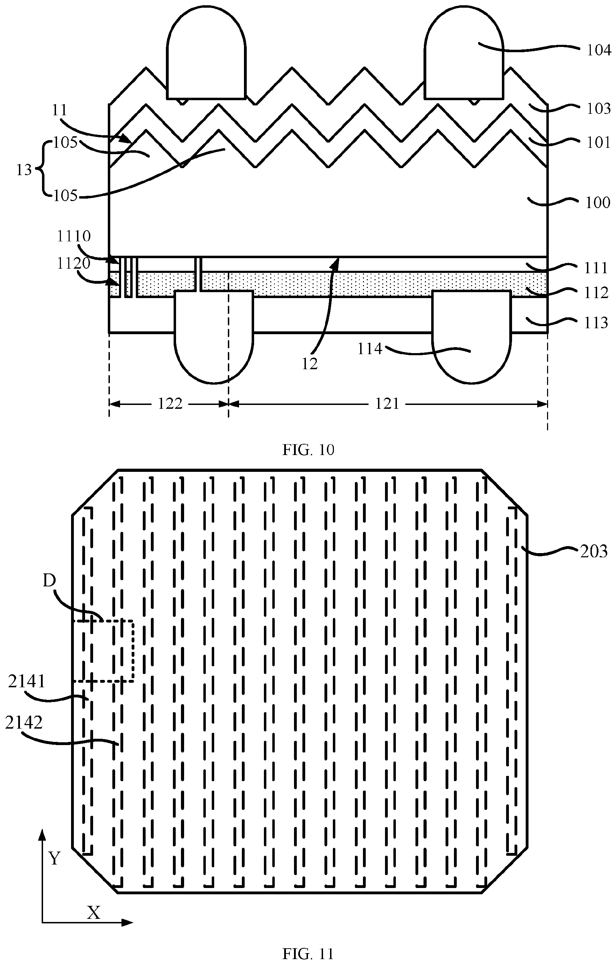

FIG. 10 is a schematic diagram illustrating a cross-sectional view of a second structure of a solar cell in accordance with an embodiment of the present disclosure. In some embodiments, with reference to FIG. 10, a portion of electrodes 114 are arranged in the first holes 1120 and in electrical contact with the substrate. This portion of electrodes 114 are in direct electrical contact with the substrate 100 through the first holes 1120, so that the electrodes 114 can directly collect carriers generated by the substrate 100. The first holes 1120 may serve as an additional conductive channel to improve a current collection efficiency of the edge region, and counteract an effect of less efficient caused by a pinhole effect of the dielectric layer 111.

In some embodiments, the electrodes 114 may be partially located at the edge region 122. In some embodiments, the electrodes 114 may be located entirely at the edge region 122.

With continued reference to FIG. 3, the solar cell further includes an emitter 101 disposed on the first surface 11, another passivation layer 103 formed over the emitter 101, and fingers 104 passing through the another passivation layer 103 and in electrical contact with the emitter 101.

In some embodiments, the emitter 101 and the substrate 100 are of the same material, and the emitter 101 and the substrate 100 may be formed from the same original substrate after a doping process. The type of doping element within the emitter 101 is different from the type of doping element within the substrate 100. A doping process is performed on a part of the original substrate along a thickness direction of substrate, the part of the original substrate subjected to the doping process serves as the emitter and the remaining original substrate serves as the substrate.

In some embodiments, the emitter 101 is a doped layer formed over the first surface of the substrate, and is a semiconductor layer formed by a deposition process and doped with the N-type doping element or the P-type doping element. The semiconductor layer may be silicon, germanium, or polysilicon.

In some embodiments, the substrate is provided with a first textured structure 13, the first textured structure 13 includes a plurality of raised structures 105.

In some embodiments, the another passivation layer 103 may be of a single layer structure or a stacked layer structure, and may be made of one or more of silicon oxide, silicon nitride, silicon oxynitride, silicon oxycarbonitride, titanium oxide, hafnium oxide, or aluminum oxide.

In some embodiments, the another passivation layer 103 and the passivation layer 113 are of the same material, and are prepared by the same preparation process.

In some embodiments, the electrodes 114 and the fingers 104 may be obtained by sintering a burn-through paste. The method of forming the electrodes 114 includes: printing a metal paste on a portion of the surface of the passivation layer 113 by using a screen printing process. The method of forming the finger 104 includes: printing a metal paste on a portion of the surface of the another passivation layer 103 by using a screen printing process. The metal paste may include at least one of silver, aluminum, copper, tin, gold, lead, or nickel.

In some embodiments, the solar cell may be of a bifacial TOPCon cell structure, and the solar cell may further include a tunnel dielectric layer disposed on the first surface, and a doped polysilicon layer disposed on a surface of the tunnel dielectric layer. A doping type of the doped polysilicon layer is different from a doping type of the substrate, e.g., the substrate is doped with the N-type doping element, and the doped polysilicon layer is doped with the P-type doping element.

In some embodiments, the dielectric layer and the doped semiconductor layer are disposed on the first side of the substrate, and the tunnel dielectric layer and the doped polysilicon layer are disposed on the second side of the substrate.

In some embodiments, the dielectric layer and the doped semiconductor layer are disposed on the first side of the substrate, the solar cell further includes an intrinsic dielectric layer, a doped amorphous silicon layer and a transparent conductive layer. The intrinsic dielectric layer is disposed on the second surface of the substrate, the doped amorphous silicon layer is disposed on a surface of the intrinsic dielectric layer, and the transparent conductive layer is disposed on a surface of the doped amorphous silicon layer, the electrodes are in electrical contact with the doped semiconductor layer, and the fingers are in electrical contact with the transparent conductive layer.

In the solar cell provided by embodiments of the present disclosure, the doped semiconductor layer 112 has the edge region 122, the first holes 1120 are formed within the edge region 122, the passivation layer 113 is arranged in the first holes 1120 and provides passivation to the substrate, so as to make the passivation layer 113 provide passivation to the substrate 100 exposed by the doped semiconductor layer 112, to reduce surface defects of the substrate 100, and to reduce the recombination rate of the substrate 100. The first holes 1120 are formed at the edge region 122, thus a structural strength of the doped semiconductor layer 112 decreases correspondingly due to the presence of the plurality of first holes 1120 in the doped semiconductor layer 112. The doped semiconducting layer 112 with the first holes 1120 can relieve a compressive stress to which the doped semiconducting layer 112 is subjected during forming an electrode on the doped semiconducting layer 112and achieving a welding between the electrodes and solder bands and during a lamination process of a photovoltaic module, thereby reducing a chance of breakage of the doped semiconducting layer 112 at the edge and improving a yield of the solar cell.

Accordingly, in another aspect, an embodiment of the present disclosure also provide a solar cell, which is different from the embodiment described above in that, the electrodes with a first polarity and the fingers with a second polarity in the embodiments described above are disposed on the first surface and the second surface of the substrate, respectively, in the solar cell provided by another embodiment, both of a first electrode with the first polarity and a second electrode with the second polarity are disposed on the second surface of the substrate, the same or corresponding technical features as those of the above-described embodiments will not be explained in more detail here.

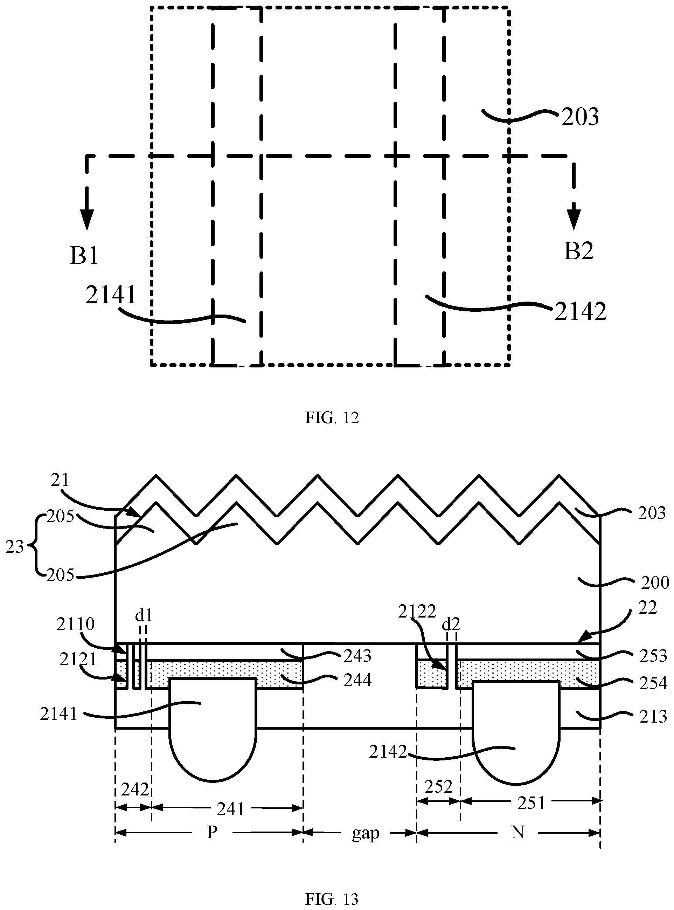

FIG. 11 is a schematic diagram illustrating another structure of a solar cell in accordance with an embodiment of the present disclosure; FIG. 12 is an enlarged partial view at D in FIG. 11; FIG. 13 is a schematic diagram illustrating a cross-sectional view taken along a line B1-B2 in FIG. 12.

Referring to FIG. 11 to FIG.13, the solar cell includes a substrate 200 and a doped semiconductor layer disposed on a side of the substrate 200. The doped semiconductor layer has an edge region, and is provided with first holes passing through the doped semiconductor layer at the edge region. The solar cell further includes a passivation layer 213 formed over the doped semiconductor layer. The passivation layer 213 fills the first holes. The solar cell further includes a plurality of electrodes arranged at intervals along a first direction, and the plurality of electrodes pass through the passivation layer 213 and are in electrical contact with the doped semiconductor layer.

In some embodiments, the substrate 200 is provided with P regions, N regions and gap regions, the P regions and the N regions are arranged alternatingly, and a respective gap region is sandwiched between a respective P region and a N region adjacent to the respective P region.

In some embodiments, the substrate 200 has a first surface 21 and a second surface 22 opposite to the first surface. The substrate 200 is provided with a first textured structure 23 on the first surface 21, and the first textured structure 23 includes a plurality of raised structrues 205. A front surface field (hereinafter FSF) is formed at the first surface 21, in which doping ion has the same conductivity type as that of the substrate 200, and a surface minority concentration is reduced by utilizing a field passivation effect, thereby reducing the surface recombination rate, while also reducing series resistance and increasing electron transport capability.

In some embodiments, referring to FIG. 13, the gap region is level with the P region and the N region, i.e., the substrate is not etched, insulation between the P region and the N region is achieved by some isolating film layers, the isolating film layer may be a passivation layer.

In some embodiments, the gap region is lower than the P-region and the gap region is lower than the N-region. That is, a groove extending from the second surface towards the first surface is defined in the gap region, so that the groove enables automatic isolation between regions of different conductivity type, so as to prevent heavily doped P-regions and N-regions in IBC cells (Interdigitated Back Contact Cells) from generating PN junctions which result in electric leakage and affect cell efficiency.

In some embodiments, the surface of the gap region may be a polished surface or the surface of the gap region may be provided with a second textured structure, the first textured structure has a roughness greater than or equal to the roughness of the second textured structure.

Therein, "roughness" refers to, an arithmetic average of absolute values of vertical deviation amounts of peaks and valleys within a sampling length (1µm) with respect to a mean horizontal line. Roughness may be measured by comparison method, optical cutting method, interferometry method and stylus method.

In some embodiments, the doped semiconductor layer includes a first doped semiconductor layer 244 at the P region and a second doped semiconductor layer 254 at the N region, the electrodes include a first electrode 2141 in electrical contact with the first doped semiconductor layer 244 and a second electrode 2142 in electrical contact with the second doped semiconductor layer 254. The passivation layer 213 further covers the surface of the substrate at the gap region. The first doped semiconductor layer 244 has a first edge region 242 and is provided with first sub-holes 2121 at the first edge region 242, and/or the second doped semiconductor layer 254 has a second edge region 252 and is provided with second sub-holes 2122 at the second edge region 252.

In some embodiments, the first sub-holes 2121 are provided at the first edge region 242, t the second sub-holes 2122 are provided at the second edge region 252, and the one-dimensional size of a single first sub-hole 2121 is less than the one-dimensional size of a single second sub-hole 2122.

In some embodiments, a region of the first doped semiconductor layer 244 other than the first edge region 242 is defined as a first sub-region 241. A region of the second doped semiconductor layer 254 other than the second edge region 252 is defined as a second sub-region 251.

In some embodiments, the dielectric layers include a first dielectric layer 243 and a second dielectric layer 253, the first doped semiconductor layer 244 is disposed on the first dielectric layer 243, and the second doped semiconductor layer 254 is disposed on the second dielectric layer 253.

In some embodiments, a second hole 2110 is provided within the first dielectric layer. The second hole 2110 is also provided within the second dielectric layer.

In some embodiments, the first dielectric layer 243 and the second dielectric layer 253 may be the same as the dielectric layer 111 in the embodiments as described above, i.e., the first dielectric layer 243 and the second dielectric layer 253 are tunnel dielectric layers. Similarly, the first doped semiconductor layer 244 as well as the second doped semiconductor layer 254 may be the doped semiconductor layer 112 in the embodiments as described above, except that the first doped semiconductor layer 244 is doped with the P-type doped element and the second doped semiconductor layer 254 is doped with the N-type doped element.

In some embodiments, the first electrode 2141 and the second electrode 2142 may be referred to the electrodes 114 in the embodiments as described above, the first textured structure 23 on the first surface 21, the raised structures 205 and the first passivation layer 203 may be referred to the first textured structure 13, the raised structures 105 and the another passivation layer 103 in the embodiments as described above, the passivation layer 213 may be referred to the passivation layer 113 in the embodiments as described above, which are not described in detail herein.

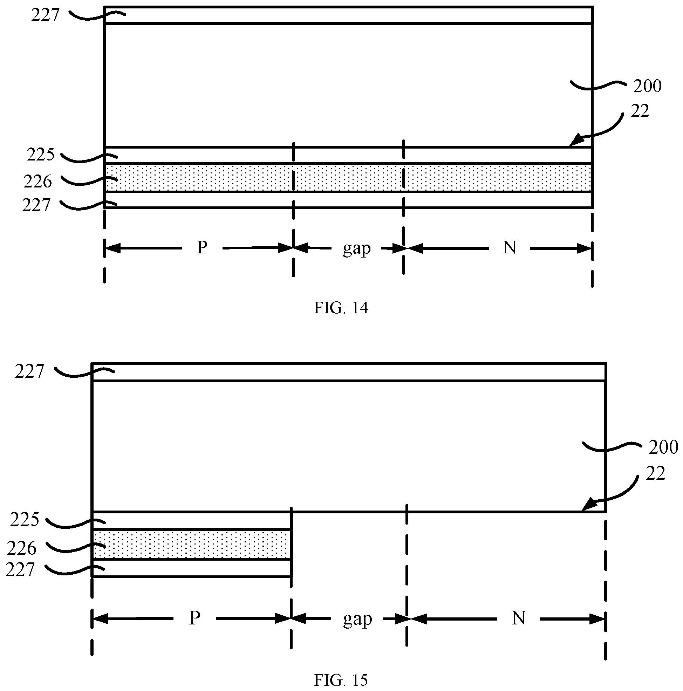

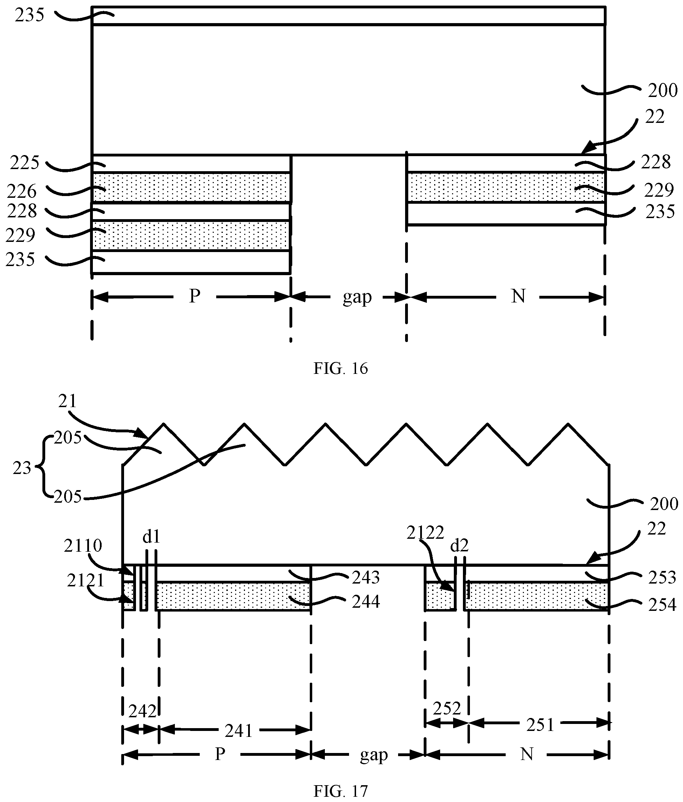

FIG. 14 is a schematic diagram illustrating a structure of a solar cell corresponding to an operation of providing a substrate in a method of preparing the solar cell in accordance with an embodiment of the present disclosure; FIG. 15 is a schematic diagram illustrating a structure of a solar cell corresponding to an operation of removing a first doped silicon glass layer in a method of preparing the solar cell in accordance with an embodiment of the present disclosure; FIG. 16 is a schematic diagram illustrating a structure of a solar cell corresponding to an operation of forming a second doped silicon glass layer in a method of preparing the solar cell in accordance with an embodiment of the present disclosure; FIG. 17 is a schematic diagram illustrating a structure of a solar cell corresponding to an operation of removing the second doped silicon glass layer in a method of preparing the solar cell in accordance with an embodiment of the present disclosure.

Referring to FIG. 14, the method of preparing the solar cell includes: providing a substrate 200 having a first surface and a second surface 22 opposite to the first surface.

In some embodiments, the substrate is provided with a P region, an N region, and a gap region is arranged between the P region and the N region.

Referring to FIG. 14, a first dielectric film 225 is formed on the second surface 22 of the substrate, and a first doped semiconductor film 226 is formed on a surface of the first dielectric film 225 away from the substrate. At the same time of forming the first doped semiconductor film 226, first doped silicon glass layers 227 are formed on the first surface of the substrate 200 and a surface of the first doped semiconductor film 226 away from the first dielectric film, respectively.

In some embodiments, the first dielectric film 225 is formed by using thermal oxygen or chemical deposition. The first dielectric film 225 is arranged at the P region, the N region, and the gap region.

In some embodiments, the preparing method for forming the first doped semiconductor film 226 includes: performing a first deposition to form an intrinsic semiconductor film, performing a second deposition to form a doped semiconductor film, and subjecting to a high temperature oxidation. During the first deposition, the deposition gas includes silane, the flow rate is controlled in a range of 100 sccm -1000 sccm, the deposition temperature is in a range of 400°C-700°C., During the second deposition, the deposition gas includes doping source gas and oxygen, the flow rate is controlled in a range of 100-3000 sccm, the deposition temperature is in a range of 700°C-1000°C. During the high temperature oxidation, the gas includes nitrogen and oxygen, the doped semiconductor film is converted into the first doped semiconductor film 226, and the first doped silicon glass layers 227 are formed on the first surface of the substrate 200 and the surface of the first doped semiconductor film 226.

Referring to FIG. 15, the first doped silicon glass layer 227 at the gap region and the N region is removed.

The first doped silicon glass layer 227 on the first surface and at the P region, as doping sources, are subjected to a high temperature diffusion processing, so that the first doped semiconductor film 226 is doped with the P-type doping elements in the first doped silicon glass layer 227 at the P region and a portion of the substrate near the first surface is doped with the P-type doping elements in the first doped silicon glass layer 227 on the first surface. After the high temperature diffusion processing, the first doped silicon glass layer 227 on the first surface and at the P region are removed.

In some embodiments, during the removal of the first doped silicon glass layer 227, the first doped semiconductor film 226 and the first dielectric film 225 may be subjected to etching processing in an etching solution, thus the first doped semiconductor film 226 and the first dielectric film 225 may be potentially removed.

Referring to FIG. 16, a second dielectric film 228 and a second doped semiconductor film 229 are formed on the surface of the substrate at the N region and on the surface of the first doped semiconductor film 226. At the same time of forming the second doped semiconductor film 229, second doped silicon glass layers 235 are formed on the first surface of the substrate 200 and the surface of the second doped semiconductor film 229.

Referring to FIG. 17, the second doped silicon glass layer 235 on the first surface, and the second doped silicon glass layer 235 at the P region are removed. The second dielectric film 228 and the second doped semiconductor film 229 at the P region are removed. The first dielectric film 225 and the first doped semiconductor film 226 at the P region serves as the first dielectric layer 243 and the first doped semiconductor layer 244, respectively. The second dielectric film 228 and the second doped semiconductor film 229 at the N region serve as the second dielectric layer 253 and the second doped semiconductor layer 254, respectively.

In some embodiments, the method includes: subjecting the first surface 21 to a texturing process such that a first textured structure 23 is provided on the first surface. The first textured structure includes a plurality of raised structures 205.

In some embodiments, the texturing process includes: chemical etching, for example, the substrate 200 may be cleaned with a mixed solution of potassium hydroxide and hydrogen peroxide solution, and specifically the first textured structure with a desired morphology may be formed by controlling the ratio of concentrations of the potassium hydroxide and hydrogen peroxide solution. In some embodiments, the first textured structure may also be formed by methods of laser etching, mechanical, plasma etching, or the like. During laser etching, laser process parameters are controlled to obtain the textured structures with the desired morphology.

In some embodiments, the etching solution for the etching process is controlled to generate first sub-holes 2121 within a portion of the first doped semiconductor layer 244 and to generate second sub-holes 2122 within the second doped semiconductor layer 254 during the removal of the first doped silicon glass layer 227 and the second doped silicon glass layer 235 and during the texturing process.

The process for removing the first doped silicon glass layer includes: removing the first doped borosilicate glass layer by using a mixed solution of a hydrofluoric acid solution and a hydrochloric acid solution and controlling a reaction time to be within 300s. Where, if the reaction time is less than 60s, the first doped silicon glass layer can be removed without causing etch damage to the first doped semiconductor film.

The process for removing the second doped borosilicate glass layer includes: removing the second doped borosilicate glass layer by using a mixed solution of a hydrofluoric acid solution and a hydrochloric acid solution and controlling the reaction time to be within 350s. Where, if the reaction time is less than 70s, the second doped silicon glass layer can be removed without causing etch damage to the second doped semiconductor film.

In some embodiments, a concentration of at least one of the hydrofluoric acid solution for removing the first doped borosilicate glass layer and the hydrofluoric acid solution for removing the second doped borosilicate glass layer is 20%-50%. The concentration of at least one of the hydrochloric acid solution for removing the first doped borosilicate glass layer and the hydrochloric acid solution for removing the second doped borosilicate glass layer is 0% - 20%.

In some embodiments, the mixed solution of hydrofluoric and hydrochloric acid for removing the first doped borosilicate glass layer and the mixed solution of hydrofluoric and hydrochloric acid for removing the second doped borosilicate glass layer are the same solution.

In some embodiments, the process parameters of the texturing process include: a mixed solution of sodium hydroxide solution, additives, and aqueous solution, a reaction temperature of 50 °C-100 °C, and a reaction time of 200s-1200s. Where, the concentration of the sodium hydroxide solution is 1%-5% and the concentration of the additives is 0.01%-1%.

Referring to FIG. 13, the preparation method includes: forming a passivation layer 213 covering the first sub-holes 2121, the second sub-holes 2122, the gap region, surfaces of the first doped semiconductor layer 244 and the second doped semiconductor layer 254.

With continued reference to FIG. 13, the preparation method includes forming a first passivation layer 203 covering the first surface 21 of the substrate 200.

In some embodiments, the passivation layer 213 and the first passivation layer 203 are formed in the same fabrication process.

With continued reference to FIG. 13, the preparation method includes: forming a first electrode 2141 and a second electrode 2142, the first electrode 2141 passes through the passivation layer 213 and is in electrical contact with the first doped semiconductor layer 244, and the second electrode 2142 passes through the passivation layer 213 and is in electrical contact with the second doped semiconductor layer 254.

In some embodiments, the method of preparing the first electrode 2141 and the second electrode 2142 includes printing a metal paste on a portion of the surface of the passivation layer 213 by using a screen printing process. The metal paste may include at least one of silver, aluminum, copper, tin, gold, lead, or nickel. Then the metal paste is subjected to a sintering process, the metal paste includes a material having highly corrosive components such as glass powder, as such, during sintering, corrosive components corrode the passivation layer 213, thereby causing the metal paste to infiltrate into the passivation layer 213 to electrically contact the first doped semiconductor layer 244 and form the first electrode 2141, and to electrically contact the second doped semiconductor layer 254 and form the second electrode 2142.

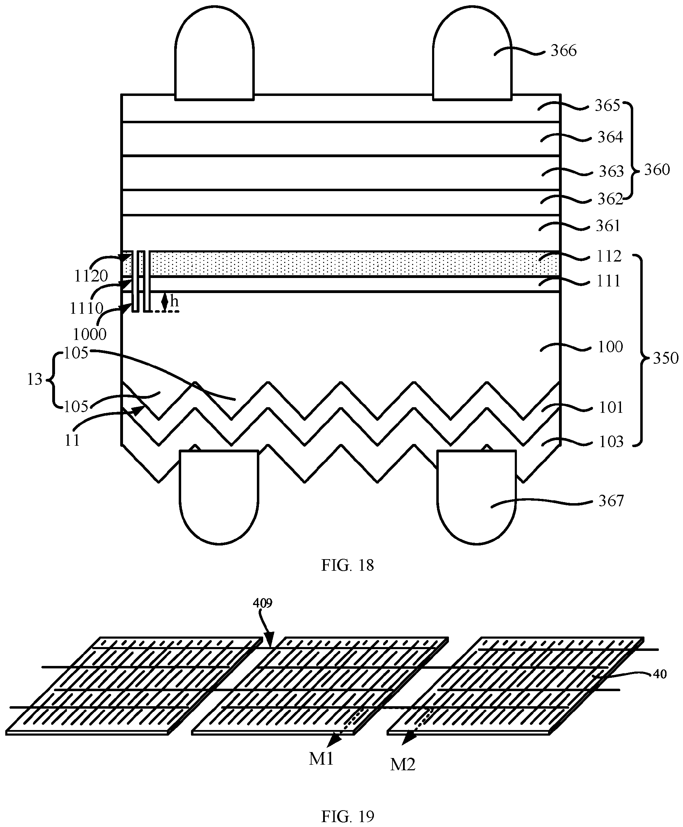

Accordingly, FIG. 18 is a schematic diagram illustrating a structure of a tandem solar cell according to an embodiment of the present disclosure. Referring to FIG. 18, an embodiment of the present disclosure provides a tandem solar cell including: a bottom cell 350, which may be the solar cell shown in the embodiments (FIG. 1 to FIG. 10), and a top cell 360 arranged on a surface of an emitter or a surface of a doped semiconductor layer surface in the bottom cell 350.

In some embodiments, the tandem solar cell includes a first finger 366 of a first polarity that is in electrical contact with the top cell 360 and a second finger 367 of a second polarity that is in electrical contact with the bottom cell 350.

In some embodiments, an interface layer 361 is arranged between the top cell and the bottom cell, the interface layer 361 fills the first holes 1120.

It is worth noting that the tandem solar cells in the embodiments of the present disclosure only illustrate two layers of solar cells, and a person skilled in the art can arrange three layers of solar cells as well as more than three layers of multilayer tandem solar cells according to practical requirements.

In some embodiments, the top cell 360 may be a perovskite solar cell. The perovskite solar cell includes a first transport layer 362, a perovskite substrate 363, a second transport layer 364, a transparent conductive layer 365, and an antireflection layer (not shown), which are stacked. The first transport layer is directly aligned with the bottom cell.

In some embodiments, the first transport layer may be one of an electron transport layer or a hole transport layer, and the second transport layer may be the other of the electron transport layer or the hole transport layer.

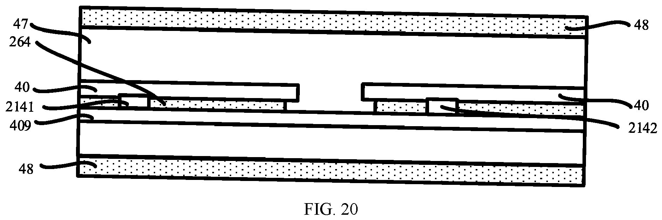

FIG. 19 is a schematic diagram illustrating a structure of a photovoltaic module in accordance with an embodiment of the present disclosure; and FIG. 20 is a schematic diagram illustrating a cross-sectional view taken along a line M1-M2 in FIG. 19.

According to some embodiments of the present disclosure, with reference to FIG. 19 and FIG. 20, in another aspect, a photovoltaic module is provided and includes: a plurality of cell strings, each formed by connecting a plurality of solar cells 40 according to any of the above embodiments, at least one encapsulation film for covering surfaces of the plurality of cell strings, at least one cover plate for covering a surfaces of the at least one encapsulation film facing away from the plurality of cell strings.

In some embodiments, the plurality of cell strings may be electrically connected via connection components 409, and the connection components 409 are welded between busbars 264 on the cells.

In some embodiments, no spacing is provided between the cells, i.e., the cells overlap with each other.

In some embodiments, the connection components are welded between fingers on the cells, the fingers include first electrodes 2141 and second electrodes 2142. In some embodiments, the connection components are welded between the busbars 264 on the cells, the busbars include first busbars welded to the first electrodes 2141 and second busbars welded to the second electrodes 2142.

In some embodiments, the at least one encapsulation film includes a first encapsulation film and a second encapsulation film, the first encapsulation film covers one of the front surface and the rear surface of the solar cell, the second encapsulation film covers the other of the front surface and the rear surface of the solar cell. Specifically, at least one of the first encapsulation film and the second encapsulation film may be an organic encapsulation film such as a Polyvinyl Butyral (PVB) film, an ethylene-vinyl acetate copolymer (EVA) film, a polyolefin elastomer (POE) film, or a polyethylene terephthalate (PET) film.

It is worth noting that there is a dividing line between the first encapsulation film and the second encapsulation film before a lamination process, and the photovoltaic module is formed after the lamination process, there is no concept of the first encapsulation film and the second encapsulation film, i.e., the first encapsulation film and the second encapsulation film already form an integral encapsulation film 47.

In some embodiments, the at least one cover plate 48 may be the cover plate having a light transmitting function, such as a glass cover plate, a plastic cover plate. Specifically, the surface of the at least one cover plate 48 facing the encapsulation film 47 may be an uneven surface, thereby increasing the utilization rate of the incident light. The at least one cover plate 48 include a first cover plate and a second cover plate, the first cover plate faces the first encapsulation film, and the second cover plate faces the second encapsulation film; or the first cover plate faces one side of the solar cell and the second cover plate faces the other side of the solar cell.

When a certain part "includes" another part throughout the specification, other parts are not excluded unless otherwise stated, and other parts may be further included. In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "has," "having," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

A person of ordinary skill in the art may understand that, the foregoing implementations are specific embodiments for implementing the present disclosure. During actual application, various changes may be made to the forms and details without departing from the scope of the embodiments of the present disclosure. Any person skilled in the art may make various variations and modifications without departing from the spirit and scope of the embodiments of the present disclosure. Therefore, the protection scope of the embodiments of the present disclosure should be subject to a scope defined by the appended claims.

## Claims

1. A solar cell, comprising:
a substrate (100, 200);
a doped semiconductor layer (112, 244, 254), disposed on the substrate (100, 200);
holes (1120, 2121, 2122) distributed across an edge region of the doped semiconductor layer, wherein a respective hole of the holes extends through at least the doped semiconductor layer and is filled with a passivation material;
a passivation layer (113, 213), formed on a side of the doped semiconductor layer (112, 244, 254) away from the substrate (100, 200);
a plurality of electrodes (114, 2141, 2142), arranged at intervals along a first direction, extending through the passivation layer (113, 213) and in electrical contact with the doped semiconductor layer (112, 244, 254).

2. The solar cell according to claim 1, wherein the doped semiconductor layer (112, 244) is doped with P-type doping elements, and the edge region (122, 242) has a width less than or equal to 50µm in the first direction.

3. The solar cell according to claim 2, wherein the respective hole (1120, 2121) has a one-dimensional size less than or equal to 10µm.

4. The solar cell according to claim 1, wherein the doped semiconductor layer (112, 254) is doped with N-type doping elements, and the edge region (122, 252) has a width less than or equal to 300µm in the first direction.

5. The solar cell according to claim 4, wherein the respective hole (1120, 2122) has a one-dimensional size less than or equal to 30µm.

6. The solar cell according to any one of claims 1, 2 and 4, wherein the substrate (100, 200) is provided with recesses (1000), a respective recess of the recesses (1000) communicates with the respective hole (1120, 2121, 2122), and the respective recess (1000) has a depth less than 4µm.

7. The solar cell according to claim 6, wherein a portion of the plurality of electrodes (114, 2141, 2142) are arranged in the holes (1120, 2121, 2122) and are in electrical contact with the substrate (100, 200).

8. The solar cell according to claim 6, wherein the substrate (100, 200) is provided with textured structures (14) in an inner wall of the recesses (1000).

9. The solar cell according to any one of claims 1 to 8, further comprising a dielectric layer (111, 243, 253) between the substrate (100, 200) and the doped semiconductor layer (112, 244, 254), wherein the respective hole (1120, 2121, 2122) further extends through the dielectric layer to reach a surface of the substrate (100, 200).

10. The solar cell according to any one of claims 1 to 9, wherein the substrate (100, 200) is provided with P regions, N regions and gap regions, the P regions and the N regions are arranged alternatingly, a respective gap region of the gap regions is sandwiched between a respective P region of the P regions and a N region adjacent to the respective P region in the N regions;
the doped semiconductor layer includes a first portion (244) arranged at the P regions and a second portion (254) arranged at the N regions;
the plurality of electrodes include first electrodes (2141) in electrical contact with the first portion and second electrodes (2142) in electrical contact with the second portion;
the passivation layer (213) further covers a surface of the substrate (100, 200) at the gap regions; and
the first portion has a first edge region (242), a portion of the holes (2121) is provided at the first edge region (242), and/or the second portion has a second edge region (252), another portion of the holes (2122) is provided at the second edge region (252).

11. The solar cell according to claim 10, wherein a respective hole (2121) provided at the first edge region (242) has a one-dimensional size less than a one-dimensional size of a respective hole (2122) provided at the second edge region (252).

12. The solar cell according to any one of claims 1 to 11, wherein in a third direction, a ratio of a number of the first holes (1120, 2121, 2122) to a length of the edge region (122, 242, 252) is less than 0.2/µm.

13. The solar cell according to any one of claims 1 to 12, wherein the doped semiconductor layer (112, 244, 254) has a boundary (115), a number of the holes (1120, 2121, 2122) near the boundary (115) is greater than a number of the holes (1120, 2121, 2122) away from the boundary (115).

14. The solar cell according to any one of claims 1 to 13, wherein the doped semiconductor layer (112, 244, 254) includes at least one of a doped amorphous silicon layer, a doped polycrystalline silicon layer, a doped microcrystalline silicon layer, a doped silicon carbide layer, and a doped crystalline silicon layer.

15. A photovoltaic module, comprising:
at least one cell string formed by connecting a plurality of solar cells (40) according to any one of claims 1 to 14;
at least one encapsulation film (47), formed over surfaces of the at least one cell string; and
at least one cover plate (48), formed over surfaces of the at least one encapsulation film facing away from the at least one cell string.
